## Europäisches Patentamt

## European Patent Office

## Office européen des brevets

(19)

(11) Veröffentlichungsnummer: **0 019 270**
**B1**

(12) **EUROPÄISCHE PATENTSCHRIFT**

(45) Veröffentlichungstag der Patentschrift:
**16.05.84**

(51) Int. Cl.³: **B 41 M 1/18,** G 03 F 3/04

(21) Anmeldenummer: **80102671.7**

(22) Anmeldetag: **14.05.80**

(54) **Mehrfarben-Druckerzeugnis und Verfahren zur Herstellung der zu dessen Druck verwendeten Druckformen.**

(30) Priorität: **22.05.79 DE 2920647**

(43) Veröffentlichungstag der Anmeldung:
**26.11.80 Patentblatt 80/24**

(45) Bekanntmachung des Hinweises auf die Patenterteilung:
**16.05.84 Patentblatt 84/20**

(84) Benannte Vertragsstaaten:
**AT CH FR GB IT LI SE**

(56) Entgegenhaltungen:
**US - A - 2 851 370**
**US - A - 3 926 117**
**US - A - 4 017 326**

(73) Patentinhaber: **Druckerei Hans Gorius,**
**Schulgässchen 4, D-6551 Vendersheim (DE)**

(72) Erfinder: **Höhne, Dieter, Schulgässchen 4,**
**D-6551 Vendersheim (DE)**

(74) Vertreter: **Knoblauch, Ulrich, Dr.-Ing.,**
**Kühhornshofweg 10, D-6000 Frankfurt am Main 1 (DE)**

## Mehrfarben-Druckerzeugnis und Verfahren zur Herstellung der zu dessen Druck verwendeten Druckformen

Die Erfindung bezieht sich auf ein Mehrfarben-Druckerzeugnis mit einer hellen Unterlage, die übereinander mehrere gerasterte Farbschichten eines Farbsatzes, insbesondere eine Blau-, Gelb-, Rot- und gegebenenfalls Schwarz-Farbschicht trägt.

Es ist bekannt, farbige Bilder in der Weise zu drucken, daß mehrere Farben eines Farbsatzes, nämlich Blau (Cyan), Gelb, Rot (Magenta) und gegebenenfalls Schwarz (Tiefe), in unterschiedlicher Verteilung auf die Unterlage aufgedruckt werden. Die Farbverteilung in jeder einzelnen Schicht ergibt sich durch die Größe der Rasterpunkte. Die helle Farbe der Unterlage, insbesondere des weißen Papiers, dient dazu, lichtere Stellen des Bildes darzustellen, indem dort keine oder nur kleine Rasterpunkte gedruckt werden.

Bei der Herstellung der Druckformen für die verschiedenen Farbschichten wird beim Offset-Druckverfahren in der Weise vorgegangen, daß von der Vorlage Farbauszüge als schwarz-weiße Positiv-Filme gefertigt werden, was durch Fotografieren der Vorlage unter Zwischenschaltung eines Komplementärfarben-Filters geschieht. Diese Positiv-Filme können unmittelbar gerastert sein; sie können auch als Haibton-Farbauszug hergestellt werden, von denen dann ein gerasterter Positiv-Film gefertigt wird. Diese gerasterten Positiv-Filme dienen zur Belichtung der Offset-Druckformen in der Weise, daß die schwarzen Teile des Positiv-Films später der Farbübertragung dienen. Es ist auch bekannt, Offset-Druckformen mittels Negativ-Filmen zu belichten. Ähnliche Verfahren gibt es nicht nur für den Flachdruck, sondern auch für den Hoch- und Tiefdruck.

Es ist ferner bekannt, Druckfarben ein Perlglanzpigment beizufügen, um diesen Farben einen gewissen Glanz zu verleihen (z. B. US-A-4 017 326).

Der Erfindung liegt die Aufgabe zugrunde, ein Mehrfarben-Druckerzeugnis der eingangs beschriebenen Art anzugeben, das stärkere Aufhellungen erlaubt und dadurch eine erhöhte Kontrastwirkung ermöglicht.

Diese Aufgabe wird erfindungsgemäß dadurch gelöst, daß eine der obersten Farbschicht benachbarte, gerasterte Zusatzschicht, die transparent ist, ein Perlglanzpigment enthält und an lichteren Stellen stärker als an dunkleren Stellen aufgetragen ist, vorgesehen ist.

Auf diese Weise entsteht ein Druckbild von starker Kontrastwirkung und Brillanz. Das Perlglanzpigment erhöht die Helligkeit an der betreffenden Stelle, sei es die Helligkeit der Unterlage, sei es die Helligkeit einer Farbschicht, wenn diese einen hellen Farbstoff enthält Auf diese Weise kann der Kontrastreichtum eines Bildes nicht nur durch Verwendung einer dunklen Farbe, wie Schwarz, sondern auch durch Verwendung der Perlglanzpigment-Schicht erhöht werden.

Wichtig ist hierbei, daß der Perlglanzeffekt nicht gleichmäßig über das ganze Bild verteilt ist, sondern zur Hervorhebung von lichten Stellen und Halbtönen dient. Auf diese Weise lassen sich sogar Spiegel- und Metallglanz-Effekte drucktechnisch hervorragend wiedergeben.

Die Zusatzschicht soll der obersten Farbschicht benachbart sein, damit ein ausgeprägter Oberflächeneffekt entsteht und die Zusatzschicht nicht durch die übrigen Farbschichten wieder überdeckt wird.

Eine besonders starke Kontrastwirkung ergibt sich, wenn die Zusatzschicht unter der obersten Farbschicht angeordnet ist, weil die dann von der obersten Farbschicht nicht bedeckten Teile der Zusatzschicht optisch besonders stark hervortreten. Dies gilt insbesondere, wenn die oberste Farbschicht schwarz ist.

Besonders empfehlenswert ist ein synthetisches silberweißes Perlglanzpigment auf der Grundlage von Kaliglimmer mit einem Überzug aus Titandioxid. Dieses Pigment läßt sich mit Hochglanzeffekt herstellen und unterstützt durch seine weiße Farbe den hellen Untergrund. Es kommen aber auch andere bekannte Perlglanzpigmente in Betracht, beispielsweise basisches Bleicarbonat.

Darüber hinaus kann die oberste Schicht als Farbstoff Transparentweiß enthalten. Hierdurch kommt das Perlglanzpigment und die helle Farbe der Unterlage bei der Darstellung der lichten Stellen des Bildes besonders zur Wirkung.

Ein Verfahren zur Herstellung der zum Druck des Mehrfarben-Druckerzeugnisses verwendeten Druckformen, bei dem für jede Farbschicht ein Film durch Farbauszug von einer Vorlage hergestellt und mit Hilfe dieses Films das Raster auf der zugehörigen Druckform erzeugt wird, ist erfindungsgemäß dadurch gekennzeichnet, daß auch für die Zusatzschicht ein Film von der Vorlage hergestellt wird, die Herstellung sich aber von der Herstellung der Filme für die übrigen Schichten durch einen photographischen Umkehrvorgang unterscheidet.

Infolge des Umkehrvorganges wird daher die Zusatz-Schicht gerade an denjenigen Stellen stärker aufgetragen, an denen sich lichtere Stellen oder Halbtöne in der Vorlage befinden. Zur Herstellung dieses Films kann ein eigenes Foto von der Vorlage gemacht werden; es können aber auch für andere Farbschichten bereits gefertigte Filme als Ausgangspunkt benutzt werden. Der Film kann mittels Farbauszug hergestellt werden oder einer einfachen Schwarz-Weiß-Aufnahme entsprechen.

Insbesondere wird der Film für die Zusatzschicht unter Verwendung des Farbauszugs einer kontrastreichen Farbe erzeugt. Dort wo die kontrastreiche Farbe eine geringere Intensität hat, wird die Zusatzschicht stärker aufgetragen. Besonders kontrastreiche Farben liegen im Bereich von blau, braun, schwarz u. dgl. Durch Wahl unterschiedlicher Farbauszüge lassen sich auch unterschiedliche Bildwirkungen erzielen.

In einem besonders einfachen Fall wird der Film für die Zusatzschicht unter Verwendung des Farbauszugs für die Farbe Blau erzeugt.

Des weiteren kann der Film für die Zusatzschicht unter Berücksichtigung der Farbauszüge für die anderen Farben der Vorlage korrigiert werden. Beispielsweise ist es empfehlenswert, an den Stellen, wo sich ein starker Rotanteil oder ein starker Gelbanteil befindet, den Film derart zu korrigieren, daß die oberste Schicht schwächer aufgetragen wird.

Bei einem Offset-Druckverfahren, bei dem durch Farbauszug Positiv-Filme für die einzelnen Farbschichten hergestellt werden, empfiehlt es sich, daß für die Zusatzschicht ein Negativ-Film hergestellt wird. Dieser Negativfilm kann direkt von der Vorlage her belichtet werden, er kann aber auch durch Umkopieren eines Positiv-Filmes entstehen.

Im einfachsten Fall wird der Negativ-Film durch Umkopieren des Blau-Positiv-Films hergestellt. Ist der letztgenannte Film bereits gerastert, entsteht der Negativ-Film sofort in verwendbarer Form.

Für eine Korrektur empfiehlt es sich, wenn der Negativ-Film durch Übereinander- und Umkopieren mindestens zweier Halbton-Positiv-Filme hergestellt wird. Durch unterschiedliche Belichtungszeiten lassen sich beim Übereinanderkopieren zusätzliche Effekte erzielen.

Eine weitere Möglichkeit der Korrektur besteht darin, daß zunächst ein Halbton-Negativ-Film hergestellt, dieser in seinen Tonwerten korrigiert und davon ein gerasterter Negativ-Film hergestellt wird. Ein Lithograph kann durch eine solche Tonwert-Korrektur eigene künstlerische Effekte zur Geltung bringen.

Die Erfindung wird nachstehend anhand zweier in der Zeichnung schematisch dargestellter Ausführungsbeispiele näher erläutert. Diese zeigen je einen schematischen Querschnitt durch eine aus Papier bestehende Unterlage mit fünf darauf gedruckten, gerasterten Schichten.

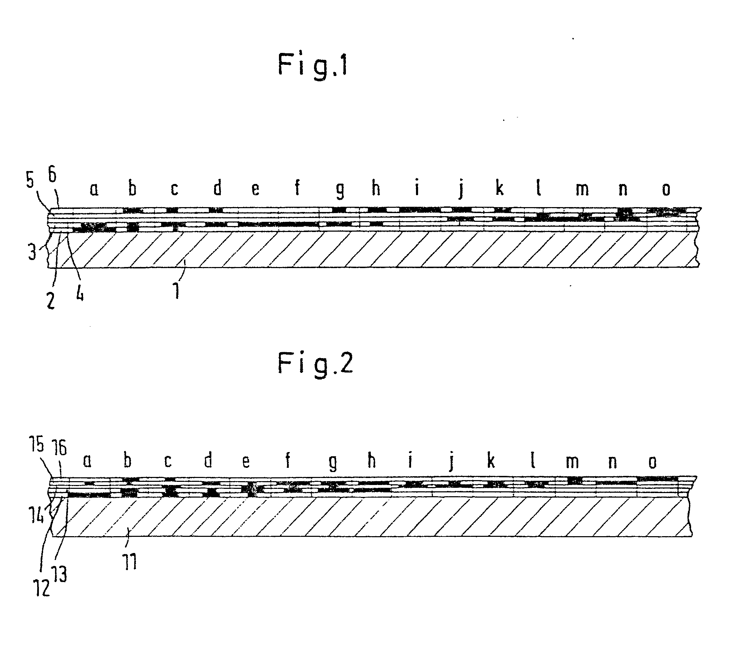

Bei Fig. 1 handelt es sich um eine Papier-Unterlage 1 mit einer schwarzen Farbschicht 2, einer blauen Farbschicht 3, einer roten Farbschicht 4, einer gelben Farbschicht 5 und einer Zusatzschicht 6 mit Perlglanzpigmenten. Diese sind beispielsweise auf einer Fünf-Farb-Maschine in der genannten Reihenfolge aufgedruckt worden. Die Herstellung kann auch auf einer Zwei-Farb-Maschine in drei Durchläufen erfolgen.

Die Zusatzschicht 6 kann sich beispielsweise wie folgt zusammensetzen:

    100 g Transparentweiß,
    100 g Drucklack,
      50 g Perlglanzpigment auf der Grundlage von mit Titandioxid überzogenem Kaliglimmer
           Irisöl zum Schlankmachen.

Es sei angenommen, daß es sich beim Ausführungsbeispiel um einen Offset-Druck handelt, bei dem die Farbschichten 2 bis 5 von Druckformen aufgetragen werden, deren Rasterpunkte mit Hilfe von durch Farbauszug hergestellten Positiv-Filmen gefertigt worden sind. Die Zusatzschicht 6 wird mittels einer Druckform aufgetragen, die mit Hilfe eines durch Farbauszug hergestellten Negativ-Films erzeugt worden ist. Hierfür wurde der Farbauszug für die Farbe Blau benutzt und anschließend eine Korrektur unter Berücksichtigung der Farbauszüge für die Farben Schwarz und Rot vorgenommen.

Dies ergibt an den Stellen a bis o Rasterpunkte unterschiedlicher Größe, die in der Figur zur besseren Veranschaulichung genau übereinander gezeichnet sind. An den Stellen e und f beträgt die Blaufärbung 100%. In der obersten Schicht ist kein Rasterpunkt vorhanden.

Ähnliches gilt für die Stelle a, wo zwar der blaue Rasterpunkt nur 60% beträgt, aber eine 100%ige Schwarz-Deckung vorgesehen ist. An den Stellen d, g und h ist die Größe des Rasterpunktes in der obersten Schicht 6 komplementär zur Größe der Rasterschicht in der blauen Farbschicht 3. Dies gilt auch an der Stelle c, wo die Schwarzkorrektur unbeachtlich klein ist. An der Stelle b ist der Rasterpunkt der Zusatzschicht 6 wegen der Korrektur durch die Farbe Schwarz etwas kleiner als es dem Komplementärwert des Rasterpunktes der Farbe Blau entsprechen würde. An der Stelle i ist überhaupt kein Farb-Rasterpunkt vorhanden; dementsprechend ergibt sich für die Zusatzschicht 6 ein 100%iger Rasterpunkt. Dies trifft auch für die Stelle o zu, wo lediglich ein nicht zur Korrektur herangezogener Gelb-Rasterpunkt und ein unbeachtlich kleiner Rot-Rasterpunkt vorhanden ist. An den dazwischen liegenden Stellen j bis n sieht man, daß aufgrund der Korrektur mit der Farbe Rot trotz Fehlens von oder sehr kleinen blauen Rasterpunkten die Größe der Rasterpunkte der obersten Schicht reduziert ist.

Fig. 2 zeigt eine Papier-Unterlage 11 mit einer blauen Farbschicht 12, einer gelben Farbschicht 13, einer roten Farbschicht 14, einer Zusatzschicht 15 mit Perlglanzpigmenten und einer schwarzen Farbschicht 16. Die Filme für den Farbsatz wurden im Direktrasterungsverfahren hergestellt, bei dem die vier Farben bereits beim Auszug aufgerastert wurden. Für die Zusatzschicht wurde ein Halbton-Auszug gemacht, der gemäß dem Motiv im Tonwert korrigiert und anschließend ebenfalls aufgerastert wurde. Hierbei kann sehr exakt auf das Motiv eingegangen werden; es besteht jedoch keine Gefahr, daß der Rasterpunkt verätzt wird.

Aus der Darstellung erkennt man, daß sich der Rasterpunkt der Zusatzschicht in starker Abhängigkeit von den anderen Farbschichten ändert. Dort, wo eine starke Deckung mit anderen Farben (Stelle c) oder ein 100%iger schwarzer Rasterpunkt (Stelle o) vorhanden ist, ergibt sich überhaupt kein Rasterpunkt der Zusatzschicht 15. Dort, wo keine andere Farbe aufgetragen wird (Stelle n), ergibt sich ein 100%iger Rasterpunkt der Zusatzschicht. Die blaue Farbe (Stelle a) hat einen stärkeren Einfluß auf die Zusatzschicht als die gelbe Farbe (Stelle h).

Man kann auch in der Weise vorgehen, daß zunächst für die Herstellung des Farbsatzes Farbauszüge mittels Halbtonfilmen, die später aufgerastert und korrigiert werden, hergestellt werden. Aus diesen Halbtonfilmen wird dann durch Übereinanderkopieren auf einen Negativ-Film ein weiterer Film hergestellt, in dem die dunklen Partien des Bildes hell und die lichten Partien dunkel sind. Danach wird auch dieser Negativ-Film aufgerastert und gegebenenfalls noch partiell korrigiert. Auch hierbei kann exakt auf das Motiv eingegangen werden, ohne daß der Rasterpunkt verätzt wird.

Eine solche Korrektur bei der Herstellung des Films für die Zusatzschicht ist nicht erforderlich, wenn es sich um überwiegend helle Bilder oder um solche handelt, die sehr starke Kontraste zwischen Hell und Dunkel aufweisen. Hier genügt es, vom Blau-Positiv-Film des Farbsatzes ein Negativ durch einfaches Umkopieren auf einen Negativ-Film herzustellen.

Bei der Herstellung von Druckerzeugnissen nach anderen Druckverfahren kann in ähnlicher Weise vorgegangen werden.

**Patentansprüche**

1. Mehrfarben-Druckerzeugnis mit einer hellen Unterlage, die übereinander mehrere gerasterte Farbschichten eines Farbsatzes, insbesondere eine Blau-, Gelb-, Rot- und gegebenenfalls Schwarz-Farbschicht trägt, gekennzeichnet durch eine der obersten Farbschicht (5, 16) benachbarte, gerasterte Zusatzschicht (6, 15), die transparent ist, ein Perlglanzpigment enthält und an lichteren Stellen stärker als an dunkleren Stellen aufgetragen ist.

2. Mehrfarben-Druckerzeugnis nach Anspruch 1, dadurch gekennzeichnet, daß die Zusatzschicht (15) unter der obersten Farbschicht (16) angeordnet ist.

3. Druckerzeugnis nach Anspruch 1 oder 2, gekennzeichnet durch ein synthetisches silberweißes Perlglanzpigment auf der Grundlage von mit Titandioxid überzogenem Kaliglimmer.

4. Druckerzeugnis nach einem der Ansprüche 1—3, dadurch gekennzeichnet, daß die Zusatzschicht (6, 15) Transparentweiß enthält.

5. Verfahren zur Herstellung der zum Druck des Mehrfarben-Druckerzeugnisses nach einem der Ansprüche 1—4, verwendeten Druckformen, bei dem für jede Farbschicht ein Film durch Farbauszug von einer Vorlage hergestellt und mit Hilfe dieses Films das Raster auf der zugehörigen Druckform erzeugt wird, dadurch gekennzeichnet, daß auch für die Zusatzschicht ein Film von der Vorlage hergestellt wird, die Herstellung sich aber von der Herstellung der Filme für die übrigen Schichten durch einen photographischen Umkehrvorgang unterscheidet.

6. Verfahren nach Anspruch 5, dadurch gekennzeichnet, daß der Film für die Zusatzschicht unter Verwendung des Farbauszugs einer kontrastreichen Farbe erzeugt wird.

7. Verfahren nach Anspruch 6, dadurch gekennzeichnet, daß der Film für die Zusatzschicht unter Verwendung des Farbauszugs für die Farbe Blau erzeugt wird.

8. Verfahren nach Anspruch 6 oder 7, dadurch gekennzeichnet, daß der Film für die Zusatzschicht unter Berücksichtigung der Farbauszüge für die anderen Farben der Vorlage korrigiert wird.

9. Verfahren, bei dem für den Offset-Druck durch Farbauszug Positiv-Filme für die einzelnen Farbschichten hergestellt werden, nach einem der Ansprüche 5—8, dadurch gekennzeichnet, daß für die Zusatzschicht ein Negativfilm hergestellt wird.

10. Verfahren nach Anspruch 9, dadurch gekennzeichnet, daß der Negativ-Film durch Umkopieren des Blau-Positiv-Films hergestellt wird.

11. Verfahren nach Anspruch 9, dadurch gekennzeichnet, daß der Negativ-Film durch Übereinander- und Umkopieren mindestens zweier Halbton-Positiv-Filme hergestellt wird.

12. Verfahren nach einem der Ansprüche 9—11, dadurch gekennzeichnet, daß zunächst ein Halbton-Negativ-Film hergestellt, dieser in seinen Tonwerten korrigiert und davon ein gerasterter Negativ-Film hergestellt wird.

**Claims**

1. Multi-colour print product with a light-coloured substrate which supports one above the other several mosaic colour layers of a set of colours, especially blue, yellow, red and if necessary a black colour layer, characterised in that adjacent to the top colour layer (5, 15) there is arranged a half-tone additional layer (6, 16) which is transparent, which contains a pearl gloss pigment and which is applied more heavily to the lighter areas than to the darker areas.

2. Multi-colour print product according to claim 1, characterised in that the addition layer (15) is arranged beneath the top colour layer (16).

3. Print product according to claim 1 or 2, characterised by a synthetic silver-white pearl gloss pigment based on potash mica coated with titanium dioxide.

4. Print product according to one of the claims 1 to 3, characterised in that the addition layer (6, 15) contains transparent white.

5. Method for producing the printing blocks used for printing the multi-colour print product according to one of the claims 1 to 4, is which a film is made for each colour layer by colour selection from a pattern and with the aid of this film the screen is produced on the associated printing block, characterised in that for the addition layer also a film is produced from the pattern, however, the production being achieved by a photographic reversing process, which is different from the production of the films for the remaining layers.

6. Method according to claim 5, characterised in that the film for the addition layer is produced by means of colour selection from a colour rich in contrast.

7. Method according to claim 6, characterised in that the Film for the addition layer is produced by using the colour selection for the colour blue.

8. Method according to claim 6 or 7, characterised in that the film for the addition layer is corrected with regard to the colour selection for the other colours of the pattern.

9. Method for offset printing in which by chromatic selection positive films are produced for the separate colour layers according to one of the claims 5 to 8, characterised in that a negative film is produced for the addition layer.

10. Method according to claim 9, characterised in that the negative film is produced by optical printing of the blue positive film.

11. Method according to claim 9, characterised in that the negative film is produced by superimposing and optically printing at least two half-tone positive films.

12. Method according to one of the claims 9 to 11, characterised in that initially a half-tone negative film is produced, this has its tone values corrected and from this is made a half-tone negative film.

**Revendications**

1. Imprimé polychrome présentant un fond clair qui porte plusieurs couches colorées tramées superposées d'une composition colorale, notamment des couches bleue, jaune, rouge et éventuellement noire, caractérisé par une couche tramée additionnelle (6, 15) contiguë à la couche colorée supérieure (5, 16), couche additionelle qui est transparente, contient un pigment nacré et est appliquée plus fortement sur les plages les plus claires que sur les plages les plus sombres.

2. Imprimé polychrome selon la revendication 1, caractérisé en ce que la couche additionnelle (15) est disposée sous la couche colorée supérieure (16).

3. Imprimé selon l'une quelconque des revendications 1 et 2, caractérisé par un pigment synthétique nacré argenté sur fond de mica argentin revêtu de bioxyde de titane.

4. Imprimé selon l'une quelconque des revendications 1 à 3, caractérisé en ce que la couche additionelle (6, 15) contient un blanc transparent.

5. Procédé pour fabriquer les supports d'impression utilisés pour l'obtention des imprimés polychromes selon l'une quelconque des revendications 1 à 4, selon lequel, pour chaque couche colorée, une pellicule est formée par extraction ou séparation de couleur à partir d'un modéle et la trame est formée à l'aide de cette pellicule sur le support d'impression correspondant, caractérisé en ce que, pour la couche additionnelle, une pellicule est aussi formée à partir du modèle, mais la fabrication diffère de celle des pellicules des autres couches par un processus d'inversion photographique.

6. Procédé selon la revendication 5, caractérisé en ce que la pellicule pour la couche additionnelle est formée en utilisant pour la séparation colorée une couleur contrastée.

7. Procédé selon la revendication 6, caractérisé en ce que la pellicule pour la couche additionnelle est formée en utilisant la séparation colorée pour la couleur bleue.

8. Procédé selon l'une quelconque des revendications 6 et 7, caractérisé en ce que la pellicule pour la couche additionelle est corrigée en observant les séparations colorées pour les autres couches du modèle.

9. Procédé selon lequel, pour l'impression offset par séparation de couleurs, des pellicules positives sont formées pour les couches colorées individuelles, conformément à l'une quelconque des revendications 5 à 8, caractérisé en ce qu'une pellicule négative est formée pour la couche additionnelle.

10. Procédé selon la revendication 9, caractérisé en ce que la pellicule négative est formée par copie de la pellicule positive bleue.

11. Procédé selon la revendication 9, caractérisé en ce que la pellicule négative est formée par copie et superposition d'au moins deux pellicules positives en demiteinte.

12. Procédé selon l'une quelconque des revendications 9 à 11, caractérisé en ce que l'on forme d'abord une pellicule négative en dimi-teinte, en ce qu'on la corrige en sa teinte normale et en ce que l'on en forme une pellicule tramée négative.

# Fig.1

# Fig.2